Europäisches Patentamt

European Patent Office

Office européen des brevets

(19)

(11) Numéro de publication : **0 597 737 A1**

## (12) DEMANDE DE BREVET EUROPEEN

(21) Numéro de dépôt : **93402406.8**

(22) Date de dépôt : **01.10.93**

(51) Int. Cl.⁵ : **G02F 1/015, H01L 29/14**

(30) Priorité : **13.10.92 FR 9212211**

(43) Date de publication de la demande :
**18.05.94 Bulletin 94/20**

(84) Etats contractants désignés :
**DE GB IT**

(71) Demandeur : **THOMSON-CSF**
**173, Boulevard Haussmann**
**F-75008 Paris (FR)**

(72) Inventeur : **Dupont, Emmanuel, Thomson CSF**
**SCPI, BP 329**
**F-92402 Courbevoie Cedex (FR)**
Inventeur : **Delaport, Dominique, Thomson CSF**
**SCPI, BP 329**
**F-92402 Courbevoie Cedex (FR)**
Inventeur : **Papuchon, Michel, Thomson CSF**
**SCPI, BP 329**
**F-92402 Courbevoie Cedex (FR)**

(74) Mandataire : **Guérin, Michel et al**
**THOMSON-CSF SCPI B.P. 329 50, rue**
**Jean-Pierre Timbaud**
**F-92402 Courbevoie Cédex (FR)**

(54) **Modulateur d'onde électromagnétique à puits quantiques.**

(57) L'invention concerne un modulateur d'onde électromagnétique comprenant une structure semiconductrice à puits quantiques présentant deux puits adjacents dont le couplage est modifié sous l'action d'un champ électrique en utilisant le phénomène d'anticroisement de niveaux en résonance. Avec ce type de modulateur on est en mesure d'atteindre 20 % de modulation (comme dans l'art antérieur) mais avec une sensibilité au champ électrique accrue et un temps de réponse très court.

FIG.4

EP 0 597 737 A1

Jouve, 18, rue Saint-Denis, 75001 PARIS

L'invention concerne un modulateur d'onde électromagnétique comprenant une structure semiconductrice à puits quantiques, fonctionnant notamment dans la gamme de longueurs d'onde 8-13 $\mu$m.

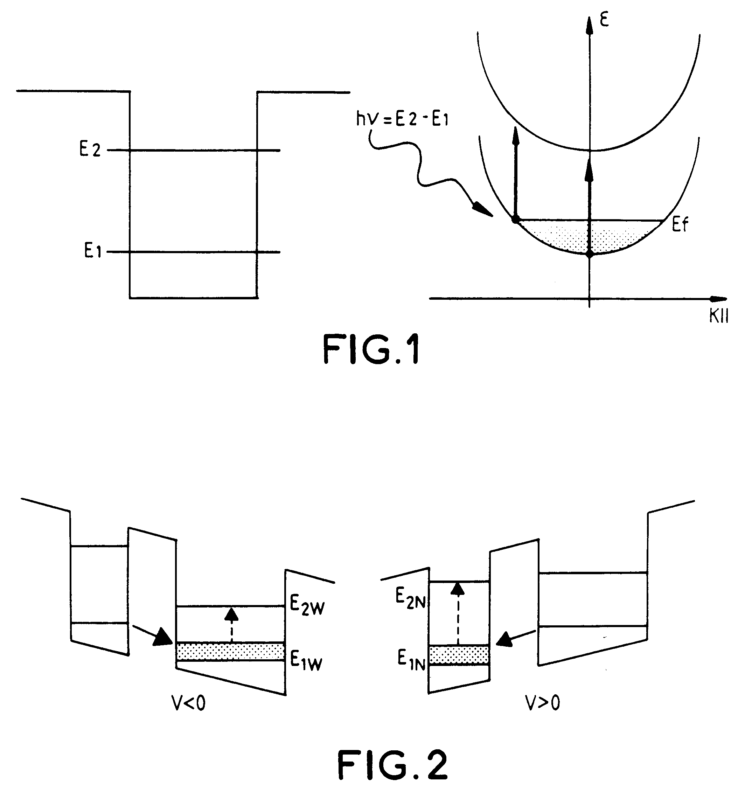

Depuis plusieurs années, l'évolution des techniques de croissance de structures semiconductrices a permis la réalisation de matériaux artificiels présentant de nouvelles propriétés de caractère quantique. En effet, l'association de semiconducteurs différents, en couches minces se traduit par des discontinuités de la bande de conduction et de la bande de valence le long de l'axe de croissance. Ces discontinuités de l'énergie potentielle des électrons, dans la bande de conduction et des trous dans la bande de valence ont été largement étudiées et exploitées dans les transistors à haute mobilité par exemple. En associant deux matériaux semiconducteurs, il est ainsi possible de former deux marches d'énergie potentielle de sens opposés et ce sur une distance plus courte que la longueur d'onde de Broglie de l'électron ou du trou. Dans un tel système, appelé puits quantique, les états électroniques ne sont plus distribués dans un continum mais dans des sous-bandes, chacune étant associée à un nombre quantique ou un niveau d'énergie. Lorsque le puits est dopé, il est possible d'induire par une onde électromagnétique de longueur d'onde $\lambda$, correctement choisie des transitions électroniques d'une sous-bande à une autre : ce sont les transitions inter sous-bandes qui sont illustrées à la figure 1. Le dipôle associé à ces transitions est de taille comparable à la largeur L du puits quantique (soit environ 0,18 L) et la densité d'état jointe est sous forme de Dirac. L'absorption du niveau fondamental noté $|0>$ vers le premier niveau excité, noté $|1>$ est donc résonante et relativement intense dans un puits symétrique.

Dans les systèmes des semiconducteurs III/V de type GaAs/GaAlAs, cette absorption est d'environ 0,3 % lorsque ces derniers sont dopés avec $10^{12}$ électrons par $cm^2$ et éclairés à incidence Brewstienne. Plusieurs solutions ont déjà été envisagées pour réaliser la modulation d'une onde électromagnétique en utilisant les transitions inter sous-bandes au sein de structure à multipuits quantiques dopés.

Une première solution s'intéresse à la modification des états et énergies Ei d'une structure multipuits quantiques, par l'application d'un champ électrique. L'écart énergétique entre niveaux est ainsi perturbé et par conséquent les énergies photoniques de résonance : $E_j - E_i = hc/\lambda_{ij}$ (avec h constante de Planck, c vitesse de la lumière, $\lambda_{ij}$ longueur d'onde), sont modifiées. Cet effet électro-optique est faible dans les structures symétriques car c'est une susceptibilité non linéaire d'ordre 3 qui est mise en jeu. Dans une structure asymétrique, cet effet est linéaire et plus efficace car c'est alors essentiellement une susceptibilité d'ordre 2 qui intervient. Les pics d'absorption se déplacent spectralement sous l'effet du champ électrique appliqué. C'est l'effet Stark, clairement démontré en 1990 ("Tunable Infrared Modulator and Switch using Stark shift in Step Quantum Wells", R.P.G. Karunasini, Y.J. Mii, K.L Wang, IEEE Electron Device Letters, Vol. 11, n°5). Se plaçant a une longueur d'onde donnée, on définit ainsi un modulateur d'amplitude et de phase par simple translation de la dispersion d'indices réel et imaginaire associée à la transition inter sous-bande et ce sous l'effet d'un champ électrique.

Une seconde solution consiste en la réalisation d'un modulateur à transfert de charge ("Tunneling assisted modulation of the inter subband absorption in double quantum wells", M. Vodjdani, D. Vinter, V. Berger, Applied Physics Letters, Vol. 59, n° 5). Ce type de dispositif vise à modifier par voie électrique la concentration $N_S$ de porteurs par unité de surface. Pour ce faire, deux puits faiblement couplés sont utilisés. A tension négative, seul le puits large est peuplé et la transition inter sous-bande est relative à ce puits. En appliquant une tension positive, les porteurs par passage tunnel sont transférés dans le puits plus étroit comme l'illustre la figure 2. Le niveau fondamental relatif à ce puits étant peuplé, une absorption inter sous-bande associée à ce puits, donc à plus courte longueur d'onde peut être mesurée. On obtient ainsi un modulateur bicolore.

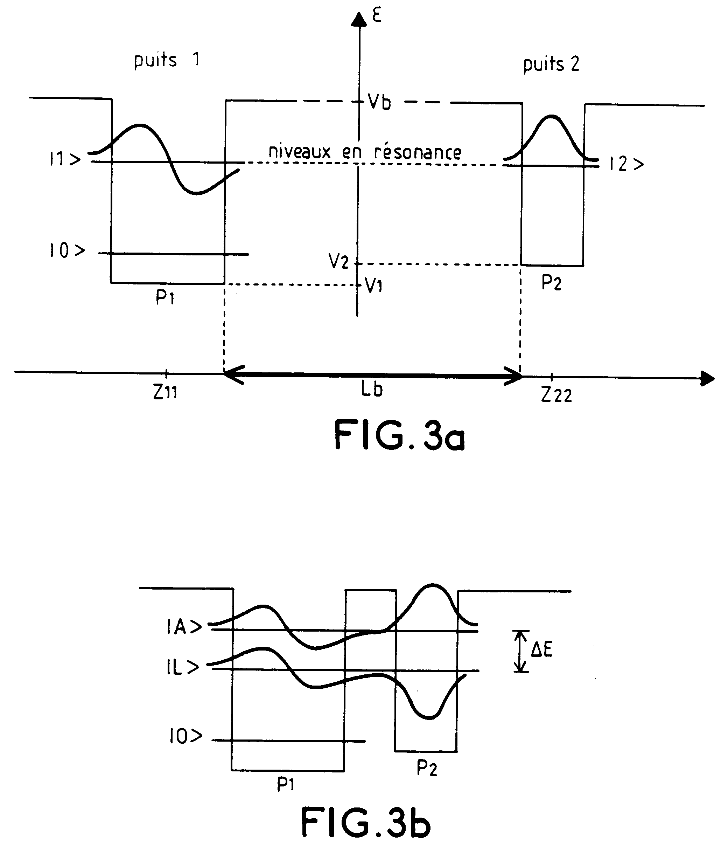

Les deux modulateurs précités possèdent des sensibilités permettant d'atteindre 20 % de modulation. La présente invention propose un modulateur dont la sensibilité est accrue et qui repose sur un autre mode de fonctionnement. En effet dans l'invention, on ne cherche plus entre deux puits adjacents sous l'action d'un champ électrique à modifier l'écart énergétique entre deux niveaux ni même à moduler la concentration électronique sur le niveau fondamental mais à changer le couplage entre deux niveaux excités. On cherche en effet, à modifier les états de deux puits couplés en appliquant le principe d'exclusion de Pauli, ou plus précisément en utilisant le phénomène d'anticroisement de niveaux en résonance. Pour cela on considère dans un premier temps, deux puits quantiques indépendants (la barrière qui les sépare est de largeur importante) pour lesquels le premier niveau $|1>$ d'énergie $\varepsilon$ excité d'un premier puits 1 est aligné avec le niveau $|2>$ d'un second puits 2. Ces niveaux sont alors dits en "résonance". La figure 3 illustre une configuration possible dans laquelle l'état excité $|1>$ est aligné avec un état $|2>$ qui est l'état fondamental du puits 2. Sur les états discrets sont représentées les fonctions d'onde dont le carré décrit la densité de probabilité de présence d'un électron sur lesdits états. En diminuant l'épaisseur de la barrière qui sépare les deux puits, les états $|1>$ et $|2>$ sont perturbés par la proximité du puits voisin. La résolution de l'équation de Schrödinger de la structure globale avec les deux puits couplés fait apparaître deux états :

- un état liant

$$|L> = \frac{1}{\sqrt{2}} (|1> + |2>)$$

- un état antiliant

$$|A> = \frac{1}{\sqrt{2}} (|1> - |2>)$$

L'écart énergétique entre ces deux niveaux n'est plus nul (phénomène d'anticroisement) et dépend notamment de l'énergie de confinement $E_c$ des niveaux non perturbés et égale à $V_b - \varepsilon$, $V_b$ représentant la hauteur de la barrière entre les deux puits.

Notons que le niveau liant est toujours de plus faible énergie que le niveau antiliant.

Sous l'effet d'un champ électrique on peut découpler les puits ; en effet sous l'action d'un champ électrique F, l'écart énergétique entre les deux niveaux $|L>$ et $|A>$ tend vers la valeur : $eF(Z_{22}-Z_{11})$ où $Z_{11}$ et $Z_{22}$ représentent les barycentres des fonctions d'onde et par la même ceux des densités de probabilité de présence d'un électron, associées aux états $|1>$ et $|2>$. En appliquant un champ électrique positif à la structure, la probabilité de présence dans le puits 1 associée à l'état liant augmente et la probabilité de présence associée à l'étant antiliant se "concentre" dans le puits 2.

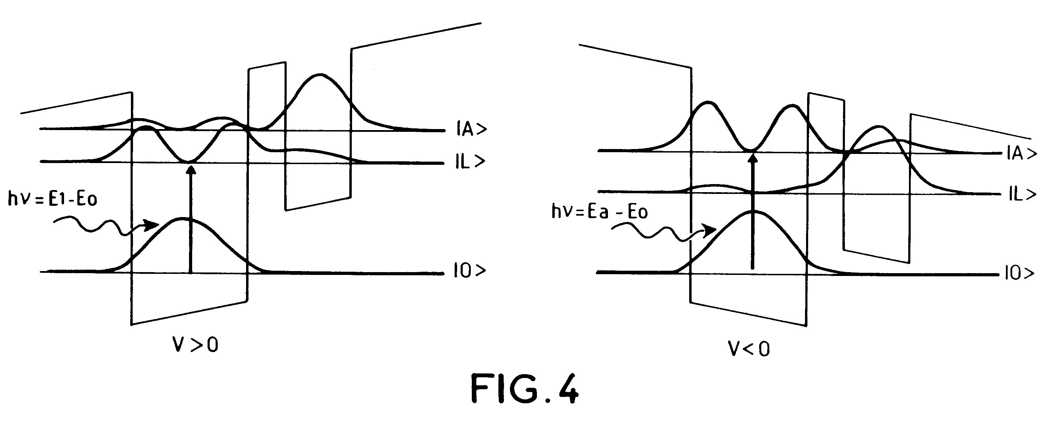

Sous l'action d'un champ électrique négatif, la probabilité de présence associée à l'état liant diminue dans le puits 1, alors que celle associée à l'état antiliant augmente au niveau dudit puits. La figure 4 illustre les comportements sous tension positive et sous tension négative des probabilités de présence d'électron sur les différents niveaux énergétiques.

En l'absence de champ électrique, on observe deux transitions inter sous-bandes $|0> ---> |L>$ et $|0 ---> |A>$ d'égale intensité puisque les états $|L>$ et $|A>$ sont des combinaisons linéaires avec des poids égaux des états $|1>$ et $|2>$ comme l'illustre la figure 3. Il est possible de favoriser l'une des deux transitions en appliquant un champ électrique. En effet, un champ électrique positif favorise la transition $|0> ---> |L>$ et un champ électrique négatif favorise la transition $|0> ---> |A>$. L'invention a donc pour objet un modulateur présentant deux absorptions inter sous-bandes dont on peut modifier l'intensité par un champ électrique. Plus précisément, l'invention propose un modulateur d'onde électromagnétique comprenant une structure semiconductrice dopée comportant un empilement de couches constituées de matériaux semiconducteurs permettant la création de puits de potentiel et comprenant des moyens de mise sous tension de la structure semiconductrice caractérisé en ce que cette structure comprend un puits de potentiel $P_1$ possédant au moins un niveau discret d'énergie $e_0$ peuplé en électrons et un niveau discret d'énergie $e_1$ tel que $e_1$ est supérieur à $e_0$, un puits de potentiel $P_2$ possédant au moins un niveau discret d'énergie $e_2$ tel que $e_2$ et $e_1$ sont égaux. Les puits $P_1$ et $P_2$ étant conçus de manière à égaler $e_1$ et $e_2$; la résonance lève

la dégénéresence entre ces deux niveaux et crée donc les états $e_L$ et $e_A$ avec $e_L$ et $e_A$ supérieurs à $e_0$ et $e_1 = e_2$ compris entre $e_L$ et $e_A$. La modulation d'une onde électromagnétique incidente résulte des variations d'absorption liées à des transitions entre d'une part les niveaux $e_0$ et $e_L$ et d'autre part les niveaux $e_0$ et $e_A$ sous l'action d'une tension appliquée à la structure.

Le modulateur selon l'invention peut avantageusement être conçu à partir d'une structure possédant deux puits quantiques $P_1$ et $P_2$, le puits $P_2$ ayant un état fondamental d'énergie $e_2$ égal à l'énergie $e_1$ du niveau excité $|1>$ du puits $P_1$.

Pour avoir levée de dégénérescence suffisante des états $|1>$ et $|2>$, les puits $P_1$ et $P_2$ doivent être suffisamment proches pour assurer le couplage recherché. Il faut pour cela qu'il y ait recouvrement des fonctions d'onde et donc que ces puits soient séparés d'une distance inférieure à la longueur d'onde de Broglie $\lambda_B$ avec $\lambda_B$ proportionnelle à $E_c^{-1/2}$ si $E_c$ représente l'énergie entre le potentiel $V_B$ de la barrière séparant les deux puits et l'énergie de l'état excité $|1>$ du puits 1. De préférence, le puits $P_1$ utilisé dans l'invention présente une énergie $E_c$ petite générant un confinement assez faible permettant ainsi d'augmenter la longueur $\lambda_B$ nécessaire au couplage des deux puits.

La structure utilisée dans l'invention peut avantageusement être élaborée à partir de deux puits $P_1$ et $P_2$ asymétriques tels que l'énergie potentielle $V_1$ du puits $P_1$ soit inférieure à l'énergie potentielle $V_2$ du puits $P_2$. Avec une telle configuration il est possible d'employer une tension de commande plus faible que celle nécessaire dans le cas d'une configuration à deux puits de même profondeur pour obtenir le même effet d'électro-absorption un système à deux puits symétriques ne fonctionnerait pas bien.

Le modulateur selon l'invention peut être par exemple réalisé à partir de matériaux $Ga_{1-x}Al_xAs$ de composition x variable.

La présente invention sera mieux comprise et d'autres avantages apparaîtront à la lecture de la description qui va suivre et des figures annexées parmi lesquelles :

- la figure 1 schématise le mécanisme de transitions inter sous-bandes obtenues dans une structure à puits quantique ;
- la figure 2 illustre le fonctionnement d'un modulateur selon l'art antérieur ;
- la figure 3 illustre la structure à puits quantiques utilisée dans un modulateur selon l'invention :
  . la figure 3a schématise les puits $P_1$ et $P_2$ dans une configuration où il n'y a pas couplage ;
  . la figure 3b schématise les puits $P_1$ et $P_2$ dans une configuration dans laquelle il y a couplage ;
- la figure 4 illustre l'évolution de densité de probabilités de présence sous l'action d'une tension appliquée à la structure utilisée dans un modulateur selon l'invention ;

- la figure 5 illustre le schéma de bande d'un exemple de structure utilisée dans un modulateur selon l'invention ;
- la figure 6 illustre les pics d'absorption d'un exemple de structure utilisée dans l'invention, en absence de champ électrique ;
- la figure 7 représente l'évolution des intensités d'absorption au niveau des transitions $|0>$ ---> $|L>$(courbe 7a) et $|0>$ ---> $|A>$ (courbe 7b) en fonction d'un champ électrique ;
- la figure 8 représente les spectres d'absorption en fonction de la longueur d'onde, pour un exemple de structure mise sous tension + 12V (courbe 8a), mise sous tension - 12V (courbe 8b), la courbe 8c donnant le rapport entre les courbes 8a et 8b.

Le modulateur d'onde électromagnétique à puits quantique selon l'invention peut avantageusement fonctionner dans la gamme 8-13 µm en étant conçu à partir de matériaux semiconducteurs classiques tels que ceux qui utilisent des concentrations intermédiaires d'aluminium dans le système GaAlAs. On peut réaliser une structure à multipuits quantiques en épitaxie par jets moléculaires sur substrat GaAs. Dans la structure quantique utilisée dans le modulateur selon l'invention, on crée des transitions inter sous-bandes à partir d'un niveau peuplé en électrons. Ce peuplement peut résulter d'un dopage n du matériau réalisé par insertion d'un plan d'atomes de silicium au milieu du puits, la concentration en porteurs électroniques pouvant être typiquement de l'ordre de $10^{+12}$ cm$^{-2}$. L'absorption d'une onde électromagnétique est de préférence enregistrée en incidence Brewsterienne (angle de 73°). Cette configuration permet d'assurer à une onde infrarouge une polarisation perpendiculaire au plan des puits, polarisation qui est la seule active au regard des transitions intrabandes électroniques. Dans le modulateur selon l'invention, le champ électrique est appliqué entre deux électrodes, ces électrodes pouvant être constituées de couches dopées n+ ($10^{18}$ électrons par cm$^3$) sur lesquelles on a réalisé des contacts ohmiques par diffusion d'un alliage AuGeNi.

En utilisant le système GaAs/GaAlAs on obtient typiquement des largeurs à mi-hauteur des pics d'absorption inter sous-bandes de l'ordre d'une dizaine de meV. Il est donc nécessaire d'élaborer une structure pour laquelle l'écart énergétique minimum $\Delta E$ entre l'écart liant $|L>$ et l'état anti-liant $|A>$ soit au moins de l'ordre de 20 à 30 meV pour séparer effectivement les deux transitions entre d'une part l'état $|0>$ et l'état $|L>$ et d'autre part entre l'état $|0>$ et l'état $|A>$. Il faut donc un espacement entre puits suffisamment faible pour qu'il y ait couplage de manière à assurer la levée de dégénérescence des états $|1>$ et $|2>$. De plus, l'efficacité de couplage et découplage des puits $P_1$ et $P_2$ sous l'action d'un champ électrique dépend fortement de la distance moyenne entre ces deux puits. Pour toutes ces raisons on peut utiliser une structure asymétrique présentant un puits $P_1$ profond et un puits $P_2$ moins profond.

A titre d'exemple, on peut indiquer les paramètres d'une structure pouvant être utilisée dans un modulateur selon l'invention. Cette structure comprend:

- un matériau "barrière" Ga$_{0,75}$Al$_{0,25}$As d'épaisseur 30 nm de potentiel $V_0$ = 242 meV;
- un puits $P_1$ de matériau GaAs d'épaisseur 8 nm de potentiel $V_1$ = 0 V;
- une barrière de couplage de matériau Ga$_{0,75}$Al$_{0,25}$As d'épaisseur 2,5 nm, de potentiel $V_b$ = 242 meV ;
- un puits $P_2$ de matériau Ga$_{0,92}$Al$_{0,05}$As d'épaisseur 4,5 nm et de potentiel $V_2$ = 87 meV.

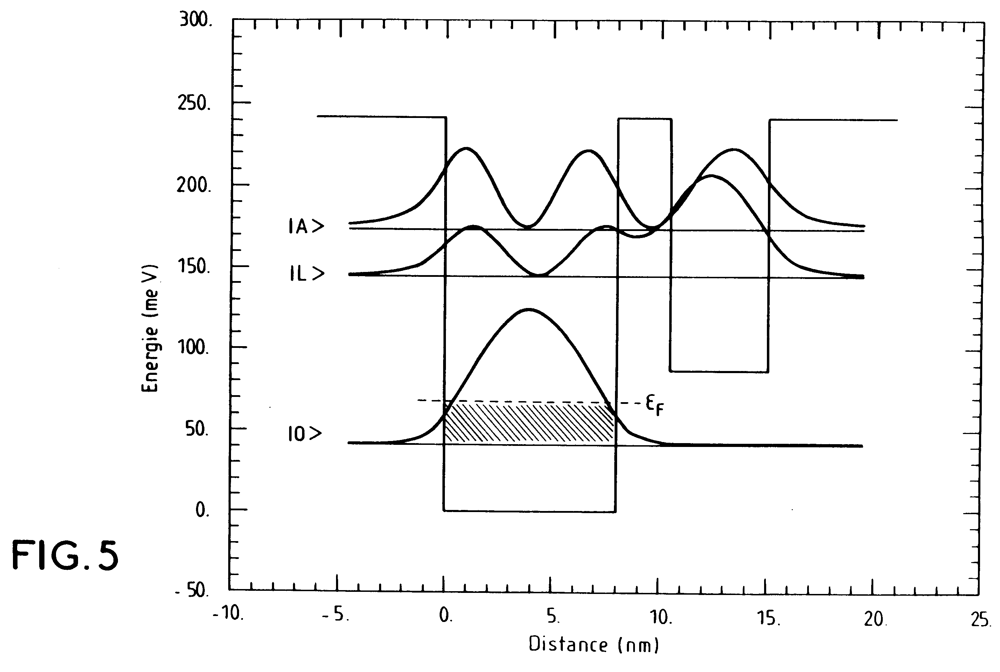

Le schéma de bande de cette structure est illustré à la figure 5.

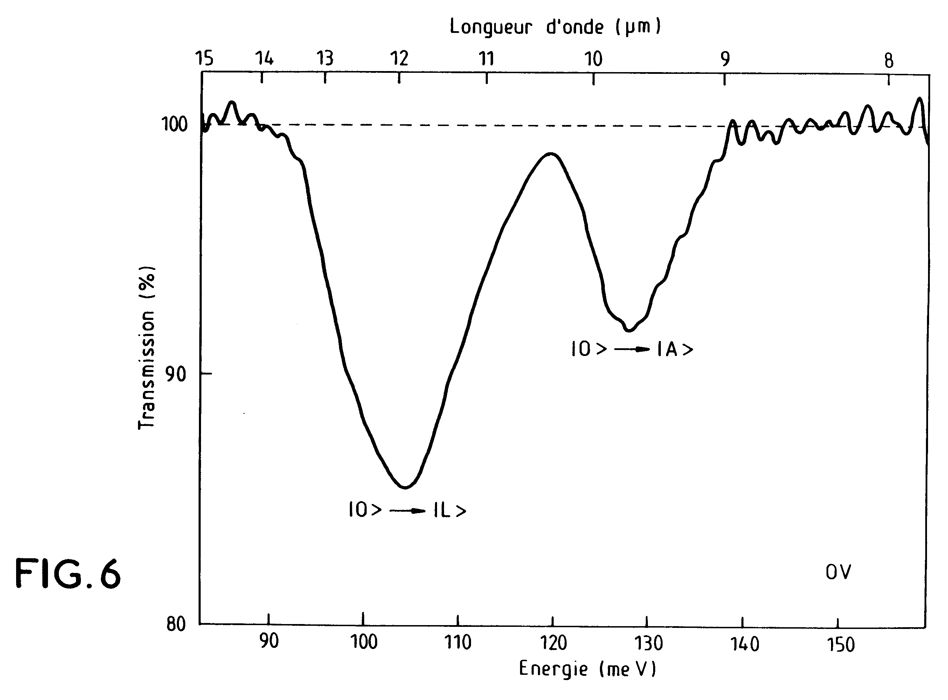

Cette structure présente des paramètres tels qu'ils permettent le couplage entre les deux puits et par conséquent l'apparition des états $|L>$ et $|A>$. Les énergies photoniques correspondant aux transitions inter sous-bandes $|0>$ ---> $|A>$ et $|0>$ ---> $|L>$ et leurs intensités sont représentées sur la figure 6 qui représente le spectre d'absorption à tension nulle, les deux pics d'absorption apparaissent clairement et sont distants d'environ 25 meV.

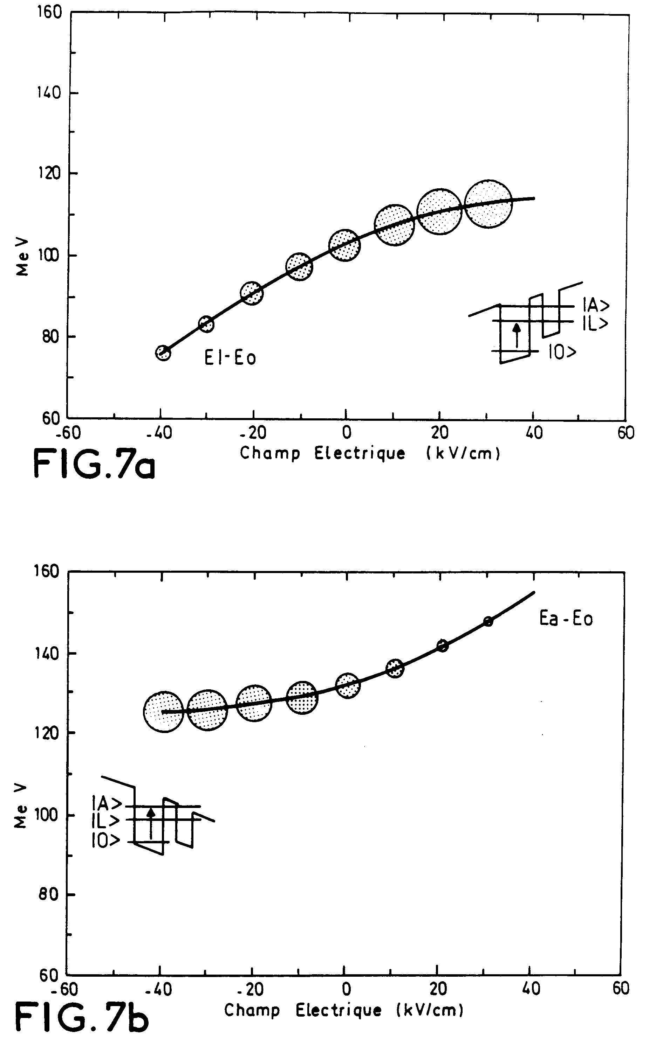

La figure 7 schématise par le diamètre des cercles l'amplitude de l'absorption d'une onde électromagnétique. La courbe inférieure 7a illustre la variation de l'intensité d'absorption liée à la transition $|0>$ ---> $|L>$ en fonction du champ électrique appliqué à la structure. La courbe supérieure 7b illustre la variation de l'intensité d'absorption liée à la transition $|0>$ ---> $|A>$. Il apparaît nettement que pour des champs positifs, la transition $|0>$ ---> $|L>$ prédomine alors que la transition $|0>$ ---> $|A>$ s'atténue d'autant plus que le champ augmente. Pour des champs électriques négatifs, appliqués à la structure le phénomène est inversé.

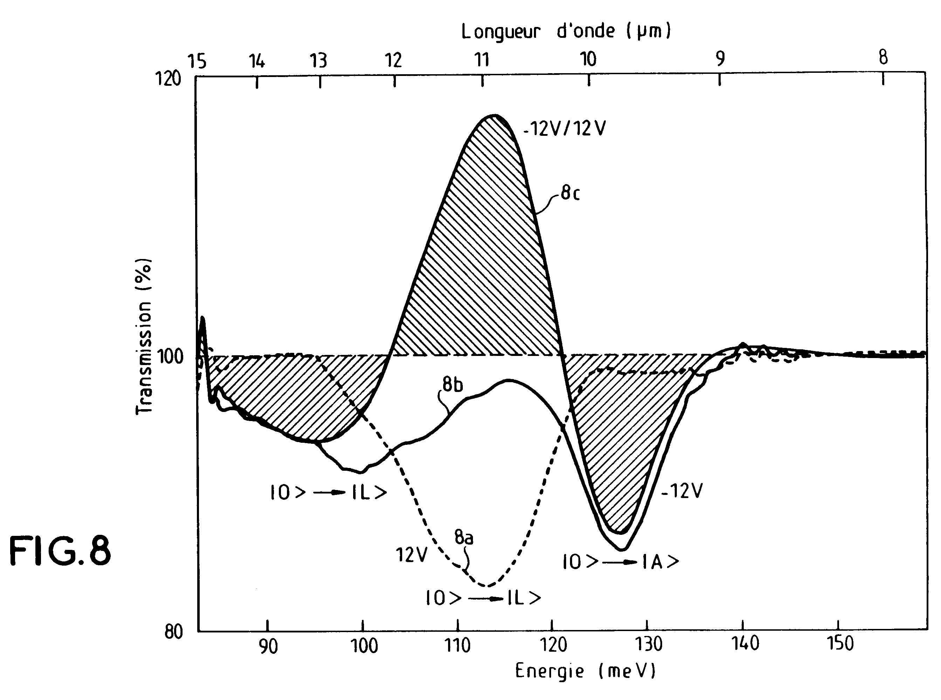

La figure 8 représente les spectres d'absorption de la structure mise sous 12 V (courbe 8a), mise sous - 12 V (courbe 8b) ; la courbe 8c illustrant le rapport des courbes précédentes. On note clairement que l'un des deux pics s'intensifie aux dépens de l'autre. Un examen du rapport des deux spectres indique que l'absorption globale est inchangée. On obtient pour une tension de commande de 24 V, 17 % de profondeur de modulation à 10,9 µm. Lorsque l'anticroisement des niveaux $|A>$ et $|L>$, $\Delta E$ est minimum, la modulation de transmission à 9,6 µm (résonance de la transition 0 ---> A) est de 0,5 % par volts de tension appliquée sur la structure. Il apparaît que ce modulateur est capable de fonctionner entre 9 et 14 µm il s'agit donc d'un dispositif large bande. La modulation peut être de plus obtenue très rapidement, le temps d'appliquer un champ électrique, soit un temps de l'ordre de la picoseconde, donc plus rapide que les modulateurs nécessitant des phénomènes de transfert de charges.

## Revendications

1. Modulateur d'onde électromagnétique comprenant une structure semiconductrice dopée comportant un empilement de couches constituées de matériaux semiconducteurs permettant la création de puits de potentiel et comprenant des moyens de mise sous tension de la structure semiconductrice caractérisé en ce que cette structure comprend un puits de potentiel $P_1$ possédant au moins un niveau discret d'énergie $e_0$ peuplé en électrons et un niveau discret d'énergie $e_1$ tel que $e_1$ est supérieur à $e_0$, un puits de potentiel $P_2$ possédant au moins un niveau discret d'énergie $e_2$ tel que $e_2$ et $e_1$ sont égaux, les puits $P_1$ et $P_2$ étant séparés d'une distance d telle qu'ils sont en résonance, la résonance créant deux états $e_L$ et $e_A$ avec $e_L$ et $e_A$ supérieurs à $e_0$ et $e_1$ = $e_2$ compris entre $e_L$ et $e_A$, la modulation d'une onde électromagnétique incidente résultant des variations d'absorption liées à des transitions entre d'une part les niveaux $e_0$ et $e_L$ et d'autre part les niveaux $e_0$ et $e_A$ sous l'action d'une tension appliquée à la structure.

2. Modulateur selon la revendication 1, caractérisé en ce que le niveau $e_2$ est le niveau fondamental du puits $P_2$.

3. Modulateur selon l'une des revendications 1 ou 2, caractérisé en ce que l'énergie potentielle $V_1$ du puits $P_1$ est inférieure à l'énergie potentielle $V_2$ du puits $P_2$.

4. Modulateur selon l'une des revendications 1 à 3, caractérisé en ce que le niveau discret d'énergie $e_0$ est peuplé par dopage de type n.

5. Modulateur selon l'une des revendications 1 à 4, caractérisé en ce que la structure semiconductrice est élaborée à partir de composés $Ga_{1-x}Al_xAs$.

## FIG.1

$$h\nu = E_2 - E_1$$

$E_{2W}$

$E_{1W}$

$E_{2N}$

$E_{1N}$

$V<0$

$V>0$

## FIG.2

FIG.3a

FIG.3b

FIG.4

FIG.5

EP 0 597 737 A1

FIG.6

EP 0 597 737 A1

FIG.7a

FIG.7b

11

FIG.8

**Office européen des brevets**

## RAPPORT DE RECHERCHE EUROPEENNE

Numero de la demande

**EP 93 40 2406**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.5) |
|---|---|---|---|
| A | IEEE JOURNAL OF QUANTUM ELECTRONICS., vol.27, no.3, Mars 1991, NEW YORK US pages 702 - 707 Y.C.CHAN ET AL. 'Field induced optical effects in coupled quantum wells' * page 702 - page 703, colonne de gauche, alinéa 1; figure 1 * | 1-5 | G02F1/015 H01L29/14 |
| A | PROC. 18TH INT.SYMP. ON GALLIUM ARSENIDE AND RELATED COMPOUNDS, SEATTLE, WA, US, 9-12 SEPTEMBER 1991 (ED. BY G.B.STRINGFELLOW) pages 625 - 630 C.SIRTORI ET AL. 'Second harmonic generation in AlInAs/GaInAs asymmetric coupled quantum wells' * page 625 - page 626; figure 1 * | 1-5 | |
| D,A | APPLIED PHYSICS LETTERS., vol.59, no.5, 29 Juillet 1991, NEW YORK US pages 555 - 557 N.VODJDANI ET AL. 'Tunneling assisted modulation of the intersubband absorption in double quantum wells' * le document en entier * | 1-5 | DOMAINES TECHNIQUES RECHERCHES (Int.Cl.5) G02F H01L |
| D,A | IEEE ELECTRON DEVICE LETTERS., vol.11, no.5, Mai 1990, NEW YORK US pages 227 - 229 R.P.G.KARUNASIRI ET AL. 'Tunable infrared modulator and switch using Stark shift in step quantum wells' * le document en entier * | 1-5 | |

Le présent rapport a été établi pour toutes les revendications

| Lieu de la recherche | Date d'achèvement de la recherche | Examinateur |
|---|---|---|
| BERLIN | 14 Février 1994 | Munnix, S |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)